# EUROPÄISCHE PATENTANMELDUNG

(11) **EP 4 683 163 A1**
(43) Veröffentlichungstag der Anmeldung: **21.01.2026**
(21) Anmeldenummer: 25187394.9
(22) Anmeldetag: 03.07.2025
(51) Int. Cl.: H02J 7/00, E04G 21/02, G01R 31/382

(54) **BETONBEARBEITUNGSVORRICHTUNG UND BETONBEARBEITUNGSVERFAHREN MIT AKKU-LAUFZEITPROGNOSE**

(30) Priorität: 11.07.2024 DE 102024119746
(71) Anmelder: Wacker Neuson Produktion GmbH & Co. KG, 85084 Reichertshofen (DE)
(72) Erfinder: BERGER, Rudolf, 82031 Grünwald (DE); EIB, Dominic, 85283 Wolnzach (DE); WEISKOPF, Alto, 85250 Altomünster (DE)
(74) Vertreter: Müller Hoffmann & Partner

(57) **Zusammenfassung**

Es wird eine Betonbearbeitungsvorrichtung angegeben, mit mindestens einem elektrischen Verbraucher (2), der wenigstens einen Elektroantrieb zum Antreiben der Betonbearbeitungsvorrichtung während eines Arbeitsvorgangs aufweist; mit mindestens einem Akku (1) zum Versorgen des Verbrauchers (2) mit elektrischer Energie; mit einer Leistungsbestimmungseinrichtung (4) zum Bestimmen eines aktuellen elektrischen Leistungsbedarfs des Verbrauchers (2) während des Arbeitsvorgangs; mit einer Ladestandsbestimmungseinrichtung (3) zum Bestimmen eines aktuellen Ladestands des Akkus (1) während des Arbeitsvorgangs; mit einer Prognoseeinrichtung (5) zum Bestimmen einer möglichen Restlaufzeit des Akkus (1) aufgrund des aktuellen Leistungsbedarfs und des aktuellen Ladestands; und mit einer Ausgabeeinrichtung (6) zum Ausgeben eines Restlaufparameters für einen Bediener, wobei der Restlaufparameter auf der Restlaufzeit beruht.

## Beschreibung

Die Erfindung betrifft eine Betonbearbeitungsvorrichtung, z.B. eine Betonverdichtungsvorrichtung zum Verdichten von noch fließfähigem Beton oder eine Glättvorrichtung zum Glätten von Oberflächen an einem flüssigen oder teilausgehärteten Beton. Weiterhin betrifft die Erfindung ein Verfahren zum Bearbeiten von Beton mit einer Betonbearbeitungsvorrichtung.

Entsprechende Betonbearbeitungsvorrichtungen sind bekannt. Für die Betonverdichtung werden z.B. Innenrüttler eingesetzt, bei denen eine durch einen Elektromotor und eine Unwucht in Schwingung versetzte Rüttelflasche (Rüttelgehäuse) in den noch fließfähigen Beton eingehängt wird, um auf diese Weise Kiesnester und Gaseinschlüsse zu lösen und zu verteilen. Auch Außenrüttler können als Betonverdichtungsvorrichtungen eingesetzt werden, indem sie auf der Außenseite von Betonschalungen angebracht werden, um diese in Schwingungen zu versetzen. Für besondere Anforderungen, z.B. bei Betonböden (z.B. Hallenböden), muss die Oberfläche von frisch vergossenem Beton geglättet werden. Dies kann mit entsprechenden Glättmaschinen, wie z.B. Vibrationsbohlen oder Flügelglättern, erreicht werden.

Beim Verdichten oder Glätten von flüssigem oder teilausgehärtetem Beton mit motorbetriebenen Rüttel- oder Glättmaschinen (Innenrüttler, Außenrüttler, Vibrationsbohlen, Flügelglätter) muss dafür gesorgt werden, dass zuverlässig eine ausreichende Anzahl von funktionsfähigen Maschinen während des Zeitfensters für den bearbeitbaren Zustand des Betons betriebsbereit zur Verfügung stehen. Dies gilt vor allem bei Großbaustellen, bei denen innerhalb kurzer Zeit große Mengen an Beton verarbeitet oder große Flächen bearbeitet werden müssen. Ist der Zeitpunkt der Bearbeitbarkeit verstrichen und die Betonaushärtung zu weit fortgeschritten, wird die Tragfestigkeit des Betons nicht mehr erreicht (mangelhafte Verdichtung) bzw. die Oberflächenglättung kann nur durch erhöhten Aufwand (Schleifen) erreicht werden.

Zunehmend werden als Betonbearbeitungsvorrichtungen Maschinen eingesetzt, die durch einen von einem Akku gespeisten Elektromotor angetrieben werden. Bei derartigen Maschinen muss dafür gesorgt werden, dass ausreichend Energie in Form von ausreichend aufgeladenen Akkus bzw. insgesamt vorhandener Akkuladekapazität im Bearbeitungsfenster zur Verfügung steht.

Bei Betonverdichtungs- oder -glättungsarbeiten mit Akku-betriebenen Maschinen muss der Prozessverantwortliche die nötige Energiemenge im Vorhinein abschätzen und für jedes Gerät Sicherheitsreserven (Überbedarfe, Redundanzen) einplanen und während des Betonageprozesses ortsnah vorhalten.

Selbst wenn eine ausreichende Anzahl von Akkus vor Ort vorhanden ist, kann es z.B. bei Innenrüttlern zu Situationen kommen, in denen der Akku genau in einem Moment leer wird und der davon gespeiste Elektromotor zum Stillstand kommt, in dem die Rüttelflasche des Innenrüttlers tief im zu verdichtenden Beton steckt. Schlimmstenfalls kann die Rüttelflasche sogar noch von Armierungseisen eingeklemmt sein und würde nur durch Fortführen des Vibrationsbetriebs wieder gelöst werden können.

Unterbricht hierbei die Vibration zu lange, weil zu viel Zeit zum Wechseln des Akkus (z.B. ein bis zwei Minuten) erforderlich ist, kann es passieren, dass der Innenrüttler nicht mehr befreit werden kann und im bereits fortgeschritten ausgehärteten Beton verloren ist. Auch kann die Qualität des Betons leiden, wenn der Akku eines Innenrüttlers zu einem Zeitpunkt leer wird, in dem der Aushärteprozess so weit fortgeschritten ist, dass eine Verdichtung zwar noch möglich ist, jedoch durch den dann notwendigen Akkuwechselvorgang zu viel Zeit verstreicht und das optimale Zeitfenster danach für eine Verdichtung geschlossen ist. Hierbei ist davon auszugehen, dass das Verdichtungszeitfenster in der Regel knapp bemessen ist und lediglich z.B. bei 30 bis 120 min, bei bestimmten Betonsorten auch erheblich kürzer, liegt.

Bei Akku-betriebenen Maschinen ist es üblich, dem Bediener eine Ladestandsanzeige zur Verfügung zu stellen, die insbesondere den Ladestand des Akkus (SOC - State Of Charge) anzeigt. Diese Information gibt dem Bediener jedoch keine genaue Auskunft über die restliche Laufzeit, da insbesondere der aktuelle Leistungsbedarf nicht berücksichtigt wird, der im Wesentlichen durch das von dem Akku gespeiste Gerät und den laufenden Prozess bestimmt wird.

Der Erfindung liegt daher die Ausgabe zugrunde, eine Betonbearbeitungsvorrichtung anzugeben, die dem Anwender eine ausreichend genaue Vorhersage über die Restlaufzeit des Akkus in Verbindung mit der aktuell verbundenen Maschine im aktuellen Prozess zur Verfügung stellen kann. Der Anwender soll damit die Möglichkeit bekommen, rechtzeitig zu einem für den Prozess günstigen Zeitpunkt den Akkuwechsel zu bestimmen bzw. vorzunehmen.

Die Aufgabe wird gelöst durch eine Betonbearbeitungsvorrichtung mit den Merkmalen von Anspruch 1 sowie durch ein Betonbearbeitungsverfahren gemäß dem nebengeordneten Anspruch. Vorteilhafte Varianten sind in den abhängigen Ansprüchen definiert.

Es wird eine Betonbearbeitungsvorrichtung angegeben, mit mindestens einem elektrischen Verbraucher, der wenigstens einen Elektroantrieb zum Antreiben der Betonbearbeitungsvorrichtung während eines Arbeitsvorgangs aufweist; mit mindestens einem Akku zum Versorgen des Verbrauchers mit elektrischer Energie; mit einer Leistungsbestimmungseinrichtung zum Bestimmen eines aktuellen elektrischen Leistungsbedarfs des Verbrauchers während des Arbeitsvorgangs; mit einer Ladestandsbestimmungseinrichtung zum Bestimmen eines aktuellen Ladestands des Akkus während des Arbeitsvorgangs; mit einer Prognoseeinrichtung zum Bestimmen einer möglichen Restlaufzeit des Akkus aufgrund des aktuellen Leistungsbedarfs und des aktuellen Ladestands; und mit einer Ausgabeeinrichtung zum Ausgeben eines Restlaufparameters für einen Bediener, wobei der Restlaufparameter auf der Restlaufzeit beruht.

Bei der Betonbearbeitungsvorrichtung kann es sich z.B. um eine Betonverdichtungsvorrichtung (Innenrüttler, Außenrüttler) oder um eine Betonglättvorrichtung (Vibrationsbohle, Flügelglätter) handeln.

Die Betonbearbeitungsvorrichtung weist mindestens einen elektrischen Verbraucher auf, er im Wesentlichen ein Elektroantrieb zum Antreiben der Betonbearbeitungsvorrichtung ist. Weiterhin können auch andere elektrische Komponenten, z.B. eine elektronische Steuerung, ein Frequenzumformer zum Wandeln von elektrischer Energie aus dem Akku in einen für den Elektroantrieb geeigneten Strom oder andere stromaufnehmende Komponenten Teil des elektrischen Verbrauchers sein.

Die Betonbearbeitungsvorrichtung kann einen oder mehrere Akkus aufweisen. Der Akku bzw. die Akkus können fest oder auswechselbar in der Betonbearbeitungsvorrichtung angeordnet sein.

Die Leistungsbestimmungseinrichtung kann ausgebildet sein zum Bestimmen des aktuellen elektrischen Leistungsbedarfs, z.B. der aktuellen Stromaufnahme während eines Arbeitsvorgangs mit der Betonbearbeitungsvorrichtung. Dabei kann z.B. auch die aktuelle Akkuspannung berücksichtigt werden. Die Leistungsbestimmungseinrichtung kann geeignete Messvorrichtungen nutzen, um die Stromaufnahme oder die Akkuspannung zu messen.

Die Ladestandsbestimmungseinrichtung ist in der Lage, den aktuellen Ladestand des Akkus zu bestimmen. Hierbei können an sich bekannte Verfahren, wie z.B. vorhandene hinterlegte Kennlinien des Akkus, Coulomb-Zählung etc. genutzt werden. Dabei kann der aktuelle Ladestand des Akkus in Beziehung zu seinem maximalen Energiegehalt ermittelt werden.

Die Prognoseeinrichtung ist ausgebildet zum Bestimmen der möglichen Restlaufzeit des Ackus. Hierbei werden der aktuelle Leistungsbedarf und der aktuelle Ladestand berücksichtigt. Die Prognoseeinrichtung kann auch Informationen über den maximal möglichen Akku-Energieinhalt besitzen, um auf Grund der gemessenen aktuell bereits verbrauchten Leistung und der aktuellen Akkuspannung Rückschlüsse auf den restlichen nutzbaren Energieinhalt des Akkus zu ziehen. Dabei kann die Prognoseeinrichtung in Form einer Software realisiert sein, um aufgrund der zu Verfügung gestellten Parameter die Restlaufzeit des Akkus zu berechnen.

Komponenten der Prognoseeinrichtung können z.B. in einer Gerätesteuereinheit der Betonbearbeitungsvorrichtung angeordnet sein. Ebenso können auch Komponenten im Akku selbst, in einem externen Gerät (Handy, Smartphone, Smartwatch, Tablet) oder einer Cloud angeordnet sein. Die Prognoseeinrichtung errechnet aufgrund der ihr vorliegenden Daten die mögliche Restlaufzeit des Akkus.

Die Restlaufzeit kann eine Zeitinformation sein, wie lange dem Akku noch elektrische Energie zum Betreiben des elektrischen Verbrauchers entnommen werden kann. Damit liegt auch eine Zeitinformation vor, wie lange die Betonbearbeitungsvorrichtung noch betrieben werden kann, also mit ihr gearbeitet werden kann.

Der aus der Restlaufzeit abgeleitete Restlaufparameter kann eine Information sein, die dem Bediener der Betonbearbeitungsvorrichtung vermittelt wird und anhand der der Bediener erkennen kann, wie lange er noch arbeiten kann. Das ist nicht nur zeitlich zu sehen, also nicht zwingend eine Zeitangabe oder eine Restlaufzeit. Vielmehr kann ergänzend oder alternativ der Restlaufparameter auch arbeitstechnisch betrachtet werden, z.B. als Information, welche Fläche durch die Betonbearbeitungsvorrichtung noch bearbeitet werden kann. Bei einem Innenrüttler kann z.B. angegeben werden, an wie vielen Eintauchstellen die Rüttelflasche des Innenrüttlers noch eingetaucht werden kann.

Dementsprechend kann der Restlaufparameter ausgewählt sein aus der Gruppe Restlaufzeit; mögliche Restfläche, die noch aufgrund der Restlaufzeit bearbeitet werden kann; mögliche Rest-Arbeitsorte, an denen aufgrund der Restlaufzeit noch gearbeitet werden kann; mögliche Rest-Arbeitsvorgänge, die typischerweise mit der Betonbearbeitungsvorrichtung aufgrund der Restlaufzeit noch abgeschlossen werden können. Diese Parameter sind auch miteinander kombinierbar, so dass auch mehrere Restlaufparameter für den Bediener angezeigt werden können.

Die Restlaufzeit ist eine reine Zeitangabe, mit der dem Bediener die Information vermittelt wird, wie lange die Betonbearbeitungsvorrichtung noch unter den gegenwärtigen Bedingungen (aktuelle Leistungsaufnahme durch den Verbraucher, aktueller Ladestand des Akkus) gearbeitet werden kann. Die Angabe der möglichen Restfläche kann z.B. sinnvoll sein, wenn die Betonbearbeitungsvorrichtung eine Glättvorrichtung ist zum Glätten der Oberfläche von teilausgehärtetem Beton. Sie ermöglicht dem Bediener abzuschätzen, ob er mit der bestehenden Akkuladung noch seine Arbeit beenden kann oder rechtzeitig einen Akkuwechsel vornehmen muss.

Als mögliche Rest-Arbeitsorte können dem Bediener z.B. Eintauchpunkte genannt werden, bei denen aufgrund der aktuellen Leistungs- und Akkudaten ein Verdichten des Betons noch möglich ist.

Für die Angabe der möglichen Rest-Arbeitsvorgänge kann ein typischer Eintauch- und Verdichtungsvorgang definiert sein. Hier wäre z.B. eine Angabe "noch 10 Rest-Arbeitsvorgänge" ein Hinweis für den Werker, dass er mit der vorhandenen Restladung des Akkus seine Arbeit insgesamt abschließen könnte.

Die Ausgabeeinrichtung ist ausgebildet, um dem Bediener in geeigneter Weise die Information über den Restlaufparameter (z.B. die Restlaufzeit oder eine der oben genannten Informationen) zu übermitteln.

Die Ausgabeeinrichtung kann eine optische Anzeige aufweisen, wobei die optische Anzeige z.B. auf der Betonbearbeitungsvorrichtung selbst und ergänzend oder alternativ auf einem Zusatzgerät, insbesondere einem mobilen Zusatzgerät, wie z.B. einem Smartphone, einer Smartwatch oder einem Tablet angeordnet sein kann. Insbesondere kann die optische Anzeige als Display verwirklicht werden. Ebenso ist es auch möglich, die optische Anzeige als Projektion auf den Boden, z.B. mit Hilfe einer Laserprojektion zu verwirklichen.

Weiterhin kann die Ausgabeeinrichtung ergänzend oder alternativ zu der optischen Anzeige eine akustische Anzeige aufweisen, z.B. in Form eines Signaltons oder einer Sprachausgabe. Auch haptische Rückmeldungen sind z.B. über einen an dem Innenrüttler vorhandenen Betonrüttlerschlauch oder an einem Handgriff eines Flügelglätters denkbar. Die haptische Rückmeldung kann z.B. als Druck oder Stoß für den Bediener spürbar sein.

Es kann eine Warnvorrichtung vorgesehen sein, zum Erzeugen eines Warnsignals, wenn die Restlaufzeit einen vorgegebenen Grenzwert unterschreitet. Auf diese Weise kann der Bediener kurz vor dem vollständigen Entleeren des Akkus gewarnt werden. Das Warnsignal kann optische, akustische oder haptische Effekte umfassen.

Die Möglichkeiten für die Bestimmung des Akkuladestands werden nachfolgend weiter erläutert. Der SOC (State-of-Charge) des Akkus und der aktuelle durchschnittliche Leistungsbedarf können während des Prozesses gemessen und mit dem maximalen Akku-Energiegehalt verglichen werden. Als maximaler Akku-Energieinhalt kann ein theoretischer Wert (z.B. beim erstmaligen Akku-Einsatz) oder ein errechneter Wert (z.B. durch Coulomb Zählung und permanente Anpassung basierend auf dem aktuellen SOH - State-of-Health) dienen. Auch können z.B. die aktuelle Umgebungs- und/oder Zelltemperatur berücksichtigt werden, da diese den aktuell abrufbaren Energieinhalt mitbestimmen. Auch Erfahrungs- oder Trainingswerte z.B. über die zu erwartende Temperaturerhöhung aufgrund des aktuellen Leistungsbedarfs können für die Berechnung der aktuell abrufbaren Energie bzw. der noch nutzbaren Restkapazität mitberücksichtigt werden.

Die Möglichkeiten für die Bestimmung der Restlaufzeit durch die Prognoseeinrichtung werden nachfolgend weiter erläutert. Als Messgrößen dienen z.B. die aktuelle Stromaufnahme, die aktuelle Akkuspannung etc. Diese können z.B. mit vorhandenen hinterlegten Kennlinien des Akkus verglichen werden, um den restlichen nutzbaren Energieinhalt des Akkus zu bestimmen. Dieser Vorgang kann laufend aktualisiert werden, evtl. durch Coulomb Zählung (Integration). Die Kennlinien des Akkus können durch laufende Referenzmessungen über die gesamte Lebensdauer des Akkus z.B. nach jedem Lade-/Entladezyklus aktualisiert werden. Die Recheneinheit kann sich entweder in der Gerätesteuereinheit, im Akku oder in einem externen Gerät, z.B. Handy oder Cloud befinden.

Als weiteres Beispiel für eine Akkureichweitenprognose dient das Glätten, wie oben bereits erläutert. Hierbei kann basierend auf den Daten der laufenden Leistungsmessung, der bisher bearbeitete Fläche und der noch zu bearbeitende Fläche dem Bediener angezeigt werden, wie weit die Fläche noch bearbeitet werden kann. Nach einem vollständigem Bearbeitungsdurchlauf kann basierend auf dem dabei gemessenen Energieverbrauch prognostiziert werden, ob und wie weit mit der restlichen Akkuladung ein weiterer Durchlauf evtl. mit einem anderem Glättwerkzeug (z.B. Finish-Flügel) möglich ist. Dabei werden idealerweise gelernte/trainierte Daten über den zu erwartenden Leistungsverbrauch durch den Wechsel des Glättwerkzeugs berücksichtigt.

Es kann eine Akku-Identifizierungseinrichtung vorgesehen sein, zum Identifizieren des Ackus. Durch Identifizieren des Akkus können der Prognoseeinrichtung präzise Informationen zum Akku übermittelt werden. Dazu kann z.B. der Akkutyp gehören und damit der vorab bekannte theoretische Wert des maximalen Akku-Energieinhalts. Ebenso können Informationen zu Akku-Kennlinien für diesen Akku bereitgestellt werden, um während des Arbeitsbetriebs den restlichen nutzbaren Energieinhalt des Akkus zu bestimmen.

Dabei kann es besonders vorteilhaft sein, wenn der Akku nicht nur hinsichtlich seines Typs oder seiner Klasse identifizierbar ist, sondern wenn der Akku eindeutig individualisiert werden kann. Dann ist es möglich, den Lebenslauf und die Entwicklung genau dieses Akkus zu dokumentieren und nachzuvollziehen, z.B. hinsichtlich seines Alters, der Anzahl von Aufladungen und Entladungen etc. Das erlaubt genaue Rückschlüsse auf die Restkapazität.

Es kann eine Temperaturmesseinrichtung vorgesehen sein, zum Bestimmen einer Umgebungstemperatur und/oder einer Zelltemperatur in dem Akku, wobei die Prognoseeinrichtung zusätzlich ausgebildet ist zum Bestimmen der möglichen Restlaufzeit des Akkus unter Berücksichtigung der aktuellen Umgebungstemperatur und/oder der Zelltemperatur. Auf diese Weise können die Temperaturen berücksichtigt werden, da sie den aktuell abrufbaren Energieinhalt mitbestimmen. Der Ladestand eines Akkus hängt nicht nur von der bis dahin erfolgten Stromentnahme, sondern auch von seiner Temperatur ab. Diese Aspekt kann mithilfe der Temperaturmesseinrichtung berücksichtigt werden.

Es kann eine Temperaturprognoseeinrichtung vorgesehen sein, zum Bestimmen einer zu erwartenden Temperaturänderung des Akkus aufgrund des aktuellen Leistungsbedarfs und aufgrund von vorab hinterlegten Informationen bezüglich eines Zusammenhangs zwischen einer Leistungsabgabe des Akkus und einer Temperaturerhöhung des Akkus. Vorab kann in diesem Fall die Information hinterlegt werden, welche Temperaturerhöhung aufgrund des aktuellen Leistungsbedarfs zu erwarten ist. Diese Information kann für die Berechnung der aktuell abrufbaren Energie bzw. der noch nutzbaren Restkapazität mitberücksichtigt werden.

Es kann eine Referenzmesseinrichtung vorgesehen sein, zum Durchführen von Referenzmessungen während eines Entladevorgangs und zum Aktualisieren der Kennlinie, die für den Akku hinterlegt sind. So können die Kennlinien des Akkus durch laufende Referenzmessungen über die gesamte Lebensdauer des Akkus z.B. nach jedem Lade-/Entladezyklus aktualisiert werden.

Es kann eine Steuereinrichtung vorgesehen sein, die wenigstens eine der folgenden Komponenten aufweist: Leistungsbestimmungseinrichtung, Ladestandsbestimmungseinrichtung, Prognoseeinrichtung. Die Komponenten können innerhalb der Betonbearbeitungsvorrichtung verteilt angeordnet sein, z.B. aber auch auf einem mobilen Endgerät, wie z.B. einem Smartphone. Vor diesem Hintergrund ist der Begriff der "Betonbearbeitungsvorrichtung" breit zu verstehen. Die Betonbearbeitungsvorrichtung kann dem entsprechend nicht nur die eigentliche Maschine bzw. das Arbeitsgerät, z.B. den Innenrüttler, umfassen, sondern auch eine weitere Systemgrenze bedeuten und z.B. Komponenten in Form einer Software oder App auf einem Geräte separat von dem eigentlichen Arbeitsgerät umfassen.

Es wird ein Verfahren zum Bearbeiten von Beton mit einer Betonbearbeitungsvorrichtung angegeben, wobei die Betonbearbeitungsvorrichtung einen elektrischen Verbraucher aufweist, der wenigstens einen Elektroantrieb zum Antreiben der Betonbearbeitungsvorrichtung während eines Arbeitsvorgangs aufweist; sowie einen Akku zum Versorgen des Verbrauchers mit elektrischer Energie; wobei das Verfahren die Schritte aufweist:
- Bestimmen eines aktuellen elektrischen Leistungsbedarfs des Verbrauchers während des Arbeitsvorgangs;
- Bestimmen eines aktuellen Ladestands des Akkus während des Arbeitsvorgangs;
- Bestimmen einer möglichen Restlaufzeit des Akkus aufgrund des aktuellen Leistungsbedarfs und des aktuellen Ladestands; und
- Ausgeben eines Restlaufparameters für einen Bediener, wobei der Restlaufparameter auf der Restlaufzeit beruht.

Diese und weitere Vorteile und Merkmale der Erfindung werden nachfolgend anhand von Beispielen näher erläutert. Es zeigen:
- **Fig. 1**: den schematischen Aufbau eines Teils einer Betonbearbeitungsvorrichtung; und
- **Fig. 2**: ein Beispiel für eine Werkerführung mit der erfindungsgemäßen Betonbearbeitungsvorrichtung.

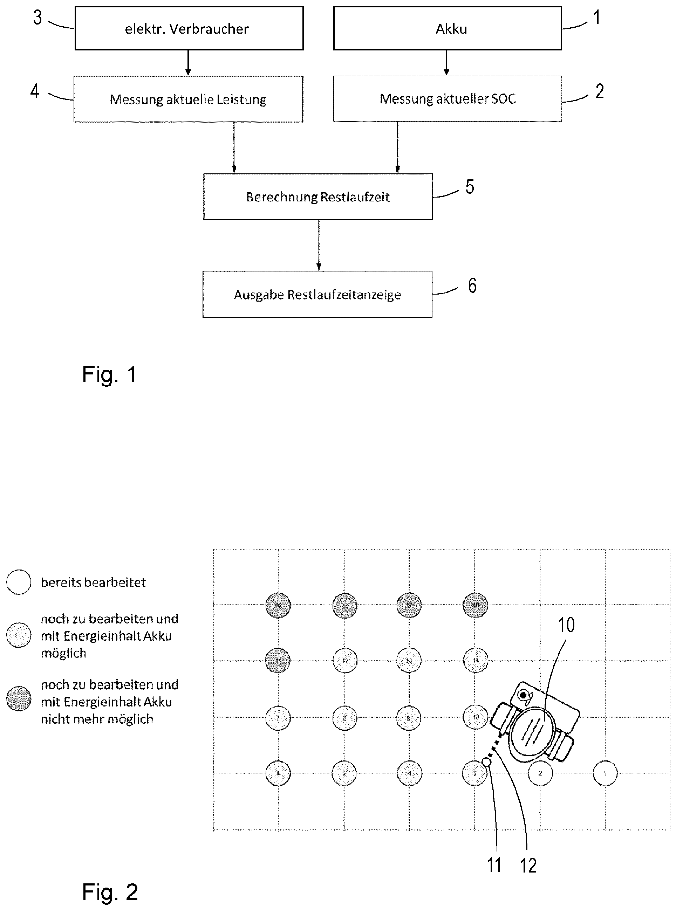

Fig. 1 zeigt in schematischer Blockdarstellung den Aufbau eines Teils der erfindungsgemäßen Betonbearbeitungsvorrichtung.

Wie oben bereits erläutert, kann die Betonbearbeitungsvorrichtung eine Betonverdichtungsvorrichtung oder eine Glättvorrichtung sein.

In Fig. 1 ist lediglich der für die Erfindung relevante Bereich dargestellt. Weitere Komponenten, wie z.B. die eigentliche Arbeitsvorrichtung zum Erzeugen einer Arbeitsbewegung (Unwuchterreger zum Erzeugen einer Rüttelschwingung; Bewegungsvorrichtung zum Bewegen bzw. Rotieren eines Glättflügels) sind nicht gezeigt.

Es ist ein Akku 1 vorgesehen, zum Versorgen eines elektrischen Verbrauchers 2, insbesondere des Elektroantriebs mit elektrischer Energie.

Eine Ladebestimmungseinrichtung 3 ist in der Lage, permanent oder in regelmäßigen Abständen den aktuellen Ladestand des Akkus 1 zu bestimmen, insbesondere während eines Arbeitsvorganges mit der Betonbearbeitungsvorrichtung.

Die dabei aktuell von dem Verbraucher 2 aufgenommene elektrische Leistung wird durch eine Leistungsbestimmungseinrichtung 4 ermittelt. Hierbei können als Messgrößen z.B. die aktuelle Stromaufnahme und die aktuelle Akkuspannung dienen.

In einer Prognoseeinrichtung 5 können auf Grund des aktuellen Leistungsbedarfs und des aktuellen Ladestands eine mögliche Restlaufzeit prognostiziert werden. Dazu können z.B. die durch die Leistungsbestimmungseinrichtung 4 ermittelten Messgrößen mit vorhandenen hinterlegten Kennlinien des Akkus 1 verglichen werden, um den restlichen nutzbaren Energieinhalt des Akkus 1 zu bestimmen. Dieser Vorgang kann laufend aktualisiert werden, z.B. durch Coulomb-Zählung (Integration). Die Kennlinien des Akkus 1 können aufgrund des vorher festgelegten Akkutyps definiert sein. Ebenso ist es dabei möglich, den Akku 1 individuell zu bestimmen, so dass individuell für genau diesen Akku 1 entsprechende Kennlinien hinterlegt werden. Die Kennlinien können zudem immer wieder, z.B. nach jedem Lade-/Entladezyklus durch laufende Referenzmessungen, aktualisiert werden. Auf diese Weise kann z.B. eine Alterung des Akkus 1 und damit eine nachlassende Ladekapazität berücksichtigt werden.

Die von der Prognoseeinrichtung 5 bestimmte Restlaufzeit wird dann durch eine Ausgabeeinrichtung 6 in geeigneter Weise ausgegeben. Die Ausgabeeinrichtung 6 kann z.B. eine Anzeige sein, auf der der Bediener die Restlaufzeit ablesen kann. Ebenso ist es möglich, die Restlaufzeit in geeigneter Weise als Restlaufparameter aufzubereiten, wie oben bereits erläutert wurde. Dadurch erhält der Bediener eine Information darüber, wie lange er unter den aktuellen Bedingungen mit der Betonbearbeitungsvorrichtung arbeiten kann.

Fig. 2 zeigt ein Beispiel für eine aufbereitete Anzeige eines Restlaufparameters in Form einer Werkerführung.

Dargestellt ist schematisch in der Draufsicht eine Betonierungsfläche, bei der ein Werker 10 eine Rüttelflasche 11 eines Innenrüttlers 12 eintaucht. Die Eintauchpunkte sind von 1 bis 18 bezeichnet.

In dem gezeigten Beispiel hat der Werker 10 die Eintauchpunkte 1 und 2 bereits bearbeitet. Das bedeutet, dass er an diesen Stellen die Rüttelflasche 11 in den zu verdichtenden Beton eingetaucht und den Beton für eine bestimmte Zeit ausreichend verdichtet hat.

Die in Fig. 2 nicht dargestellte Ausgabeeinrichtung 5 ermöglicht es dem Werker 10 zu erkennen, welche Eintauchpunkte er noch mit dem aktuellen Energieinhalt des Akkus unter der gegebenen Leistungsaufnahme des Innenrüttlers 12 bearbeiten kann. Im gezeigten Beispiel sind dies die Eintauchpunkte 3 bis 10 und 12 bis 14.

Die Eintauchpunkte 11 und 15 bis 18 hingegen können mit dem vorhandenen Energieinhalt des Akkus 1 hingegen nicht mehr bearbeitet werden. Dementsprechend kann der Werker 10 dafür Sorge tragen, dass ein vollgeladener Akku zum Auswechseln zur Verfügung steht. Wenn das Zeitfenster für die Betonverdichtung ausreichend groß ist, kann er den Akkuwechsel in Ruhe durchführen. Wenn jedoch, z.B. aufgrund der Besonderheit des zu verdichtenden Betons, das Zeitfenster für die Betonverdichtung nur sehr kurz ist, kann er z.B. mit Hilfe eines Assistenten Sorge tragen, dass der Akkuwechsel sehr schnell erfolgt und er seine Arbeit nur für wenige Sekunden unterbrechen muss.

## Patentansprüche

1. Betonbearbeitungsvorrichtung, mit
- mindestens einem elektrischen Verbraucher (2), der wenigstens einen Elektroantrieb zum Antreiben der Betonbearbeitungsvorrichtung während eines Arbeitsvorgangs aufweist;
- mindestens einem Akku (1) zum Versorgen des Verbrauchers (2) mit elektrischer Energie;
- einer Leistungsbestimmungseinrichtung (4) zum Bestimmen eines aktuellen elektrischen Leistungsbedarfs des Verbrauchers (2) während des Arbeitsvorgangs;
- einer Ladestandsbestimmungseinrichtung (3) zum Bestimmen eines aktuellen Ladestands des Akkus (1) während des Arbeitsvorgangs;
- einer Prognoseeinrichtung (5) zum Bestimmen einer möglichen Restlaufzeit des Ackus (1) aufgrund des aktuellen Leistungsbedarfs und des aktuellen Ladestands; und mit
- einer Ausgabeeinrichtung (6) zum Ausgeben eines Restlaufparameters für einen Bediener, wobei der Restlaufparameter auf der Restlaufzeit beruht.

2. Betonbearbeitungsvorrichtung nach Anspruch 1, wobei der Restlaufparameter ausgewählt ist aus der Gruppe
- Restlaufzeit,
- mögliche Restfläche, die noch aufgrund der Restlaufzeit bearbeitet werden kann,
- mögliche Rest-Arbeitsorte, an denen aufgrund der Restlaufzeit noch gearbeitet werden kann,
- mögliche Rest-Arbeitsvorgänge, die typischerweise mit der Betonbearbeitungsvorrichtung aufgrund der Restlaufzeit noch abgeschlossen werden können.

3. Betonbearbeitungsvorrichtung nach einem der vorstehenden Ansprüche, wobei die Ausgabeeinrichtung (6) wenigstens eine der folgenden Komponenten aufweist:
- optische Anzeige
- optische Anzeige, angeordnet auf der Betonbearbeitungsvorrichtung selbst
- optische Anzeige, angeordnet auf einem Zusatzgerät, insbesondere einem mobilen Zusatzgerät
- akustische Anzeige
- haptische Anzeige.

4. Betonbearbeitungsvorrichtung nach einem der vorstehenden Ansprüche, wobei eine Warnvorrichtung vorgesehen ist, zum Erzeugen eines Warnsignals, wenn die Restlaufzeit einen vorgegebenen Grenzwert unterschreitet.

5. Betonbearbeitungsvorrichtung nach einem der vorstehenden Ansprüche, wobei eine Akkuidentifizierungseinrichtung vorgesehen ist, zum Identifizieren des Akkus (1).

6. Betonbearbeitungsvorrichtung nach einem der vorstehenden Ansprüche, wobei
- eine Temperaturmesseinrichtung vorgesehen ist, zum Bestimmen einer Umgebungstemperatur und/oder einer Zelltemperatur in dem Akku (1); und wobei
- die Prognoseeinrichtung zusätzlich ausgebildet ist zum Bestimmen der möglichen Restlaufzeit des Akkus (1) unter Berücksichtigung der aktuellen Umgebungstemperatur und/oder der Zelltemperatur.

7. Betonbearbeitungsvorrichtung nach einem der vorstehenden Ansprüche, wobei eine Temperaturprognoseeinrichtung vorgesehen ist, zum Bestimmen einer zu erwartenden Temperaturänderung des Akkus (1) aufgrund des aktuellen Leistungsbedarfs und aufgrund von vorab hinterlegten Informationen bezüglich eines Zusammenhangs zwischen einer Leistungsabgabe und einer Temperaturerhöhung des Akkus (1).

8. Betonbearbeitungsvorrichtung nach einem der vorstehenden Ansprüche, wobei eine Referenzmesseinrichtung vorgesehen ist, zum Durchführen von Referenzmessungen während eines Entladevorgangs und zum Aktualisieren der Kennlinien, die für den Akku (1) hinterlegt sind.

9. Betonbearbeitungsvorrichtung nach einem der vorstehenden Ansprüche, wobei eine Steuereinrichtung vorgesehen ist, die wenigstens eine der folgenden Komponenten aufweist: Leistungsbestimmungseinrichtung (4), Ladestandsbestimmungseinrichtung (3), Prognoseeinrichtung (5).

10. Verfahren zum Bearbeiten von Beton mit einer Betonbearbeitungsvorrichtung,
wobei die Betonbearbeitungsvorrichtung aufweist
- einen elektrischen Verbraucher (2), der wenigstens einen Elektroantrieb zum Antreiben der Betonbearbeitungsvorrichtung während eines Arbeitsvorgangs aufweist; und
- einen Akku (1) zum Versorgen des Verbrauchers (2) mit elektrischer Energie;
das Verfahren mit den Schritten
- Bestimmen eines aktuellen elektrischen Leistungsbedarfs des Verbrauchers (2) während des Arbeitsvorgangs;
- Bestimmen eines aktuellen Ladestands des Akkus (1) während des Arbeitsvorgangs;
- Bestimmen einer möglichen Restlaufzeit des Akkus (1) aufgrund des aktuellen Leistungsbedarfs und des aktuellen Ladestands; und
- Ausgeben eines Restlaufparameters für einen Bediener, wobei der Restlaufparameter auf der Restlaufzeit beruht.
